# EUROPEAN PATENT SPECIFICATION

(11) **EP 1 639 056 B1**
(45) Date of publication and mention of the grant of the patent: **21.03.2012**
(21) Application number: 04776519.3
(22) Date of filing: 15.06.2004
(51) Int. Cl.: C09J 125/14, C09J 125/18, C09J 129/10, C09J 141/00, C09J 133/06

(54) **WATER-WHITENING RESISTANT LATEX EMULSION PRESSURE SENSITIVE ADHESIVE AND ITS PRODUCTION**
HAFTKLEBEMITTEL IN FORM EINER LATEXEMULSION MIT GUTEM WEISSANLAUFVERHALTEN SOWIE SEINE HERSTELLUNG
ADHESIF AUTOCOLLANT A EMULSION DE LATEX RESISTANT AU BLANCHISSEMENT PAR EAU ET PROCEDE POUR LE PRODUIRE

(30) Priority: 16.06.2003 US 462381
(43) Date of publication of application: 29.03.2006
(73) Proprietor: Ashland Licensing and Intellectual Property LLC, Dublin, OH 43017 (US)
(72) Inventor: RICHARDS, Corlyss J., Executor of the Estate, Columbus, OH 43221 (US); ZHAO, Yaqiu, Dublin, OH 43017 (US); HARVEY, Scott, R., Worthington, OH 43085 (US)
(74) Representative: Bülle, Jan
(86) International application number: PCT/US2004/018761
(87) International publication number: WO 2004/113465

(56) References cited:
- EP-A1- 0 845 518
- EP-A1- 0 845 518
- WO-A1-01/85867
- US-A- 5 620 796
- US-A- 5 885 708
- DATABASE WPI Week 199423 Thomson Scientific, London, GB; AN 1994-189178 XP002558008 & JP 06 128544 A (SUNSTAR GIKEN KK) 10 May 1994 (1994-05-10)
- DATABASE WPI Week 199711 Thomson Scientific, London, GB; AN 1997-115539 XP002558009 & JP 09 003418 A (SEKISUI CHEM IND CO LTD) 7 January 1997 (1997-01-07)

## Description

### BACKGROUND OF THE INVENTION

The present invention relates to pressure sensitive adhesives based on aqueous latex emulsions and processes for the preparation of the adhesives. Pressure sensitive adhesives prepared according to the present invention have mean particle diameter sizes of less than or equal to about 100 nm and narrow particle size distributions. These pressure sensitive adhesives are particularly suitable for applications that require that the pressure sensitive adhesive maintain adhesion between the substrate and facestock when subjected to hot water spraying or immersion. In addition, the adhesives exhibit resistance to water-whitening or "blush", often determined by a cold or ice water immersion test. Hot water adhesion is required in applications such as bottle labels where the bottles are subjected to hot water spraying in washing operations. In general, resistance to water-whitening is desirable anywhere a pressure sensitive adhesive with transparent facestock or substrate is subjected to water or high humidity. Examples include labels on the sides of trucks, signs, and bottles.

Methods of providing water-whitening resistant latex emulsions for use in pressure sensitive adhesives are disclosed in the art. U.S. Patents 5,286,843 and 5,536,811 disclose a process for improving the water-whitening resistance of pressure sensitive adhesives containing an aqueous latex emulsion and water soluble ions by removing the water soluble ions and adjusting the pH to at least about 6. The patents disclose that water-soluble ions may be removed by a number of techniques including centrifugation, dialysis, precipitation and deionization with ion exchange resins. The preferred method of removing the water-soluble ions is to contact the aqueous latex emulsion, the formulated pressure sensitive adhesive containing the aqueous emulsion or both with an ion exchange resin.

International Application WO 97/11996 discloses a process for preparing hot water-whitening resistant latex emulsions useful in pressure sensitive adhesive compositions. The process involves copolymerizing a monomer mixture containing at least one alkyl acrylate ester of an alcohol containing at least 4 carbon atoms, at least one polar co-monomer and at least one partially soluble co-monomer present in an amount of at least about 7 weight-%. Polymerization is carried out in the presence of at least one nonionic surfactant containing at least 8 moles of ethylene oxide and at least one anionic surfactant containing up to about 10 moles of ethylene oxide. The polymerization product is neutralized to produce an emulsion having a pH greater than 7 and containing particles having a volume average particle size diameter up to about 165 nm. An electrolyte may be added subsequent to polymerization to stabilize opacity of a film cast from the emulsion.

International Application WO 98/44064 discloses inherently tacky pressure sensitive adhesives prepared by emulsion polymerization of at least one monomer mixture comprising; at least one alkyl acrylate, the alkyl group of which has from 4 to 12 carbon atoms; at least one unsaturated carboxylic acid containing from about 3 to 5 carbon atoms and one styrenic monomer; wherein the particles have a mean diameter of 300 nm or less. The publication discloses a single stage preparation of aqueous acrylic emulsions in examples 4D, 4E, 4F, 4G and 4H with average particle sizes ranging from 245 nm to 139 nm. Each of the examples discloses the use of silane crosslinkers to improve blush resistance. The publication discloses a preferred method of preparation, which yields adhesives resistant to water-whitening and involves a sequential polymerization of a first and second monomer charge. None of the above references disclose a pressure sensitive adhesive that maintains adhesion in hot water environments and is resistant to water-whitening.

WO 01/85867 relates to pressure sensitive adhesives based on aqueous latex emulsions and processes for the preparation of the adhesives. The pressure sensitive adhesives have mean particle diameter sizes of less than or equal to about 100 nm and narrow particle size distributions.

EP 0 845 518 A1 relates to an aqueous emulsion for a pressure sensitive adhesive comprising a polymer prepared by polymerizing a monomer mixture, containing at least 50% by weight, based on the total weight of the monomer mixture, of a long-chain alkyl (meth)acrylate with the alkyl having 9 to 13 carbon atoms. }

### BRIEF SUMMARY OF THE INVENTION

An aqueous, blush-retardant pressure sensitive adhesive (PSA) is made from an aqueous latex emulsion having an average particle size diameter of less than or equal to about 100 nm and emulsfied in the presence of an emulsifier having the general formula: 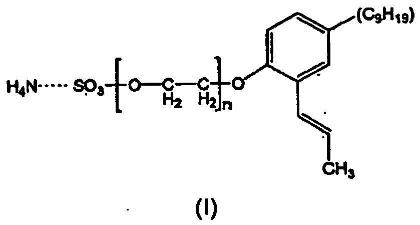 wherein n is an integer ranging from 1-200, preferably from 10-20.

The aqueous latex emulsion essentially consists of at least one alkylacrylate having at least 4 carbon atoms in the alkyl group, at least one ethylenically unsaturated carboxylic acid or its corresponding anhydride, at least one styrenic monomer, a crosslinker, a chain transfer agent, a monomer mixture comprising beta-carboxyethyl acrylate, a redox type free radical initiator system, and the emulsifier of the formula (I), and has a mean particle size diameter of less than or equal to about 100 nm.

Pressure sensitive adhesives of the present invention are useful in clear label applications, marking films, etc. The inventive pressure sensitive adhesives maintain adhesion and transparency (water-whitening resistance) when immersed in boiling water for 10 minutes. The inventive PSA's also possess good wet-out.

### DETAILED DESCRIPTION OF THE INVENTION

The polymerization is carried out in the presence of a reactive emulsifier or surfactant as described below. A redox type free radical initiator system is used in an amount sufficient to promote free radical polymerization of the monomers. Once the polymerization is complete it may be desirable to adjust the pH of the latex emulsion in order to enhance its stability. Other ingredients commonly used in the preparation of aqueous latex emulsions such as buffering agents, may be present. General latex technology is discussed in, Kirk-Othmer, Encyclopedia of Technology, [4thEd.], vol.15, p.51-65. In addition to the aqueous latex emulsion, the pressure sensitive adhesive may also contain additional components such as, biocides, wetting agents, defoamers, tackifiers, etc.

The reactive emulsifier used in the invention can be made in accordance with the procedure described in U.S. Patent No. 5,332,854.

The emulsifier used in the invention has the following general structure: 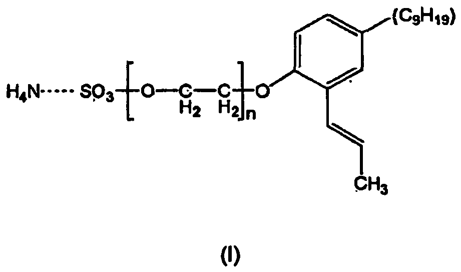 Where n is an integer ranging from 1-200, preferably from 10-20.

Examples of preferred emulsifiers included in figure (I) are commercially available from Montello (Tulsa, OK) as Hitenol BC-10 and Hitenol BC-20 poly(oxy-1,2-ethanediyl),α-sulfo-ω-[4-nonyl-2-(1-propenyl)phenyoxy]-branched ammonium salts; yellowish brownish viscous liquid, 97.0 % actives, combined sulfuric acid content of 8.70-9.70%, pH of 6.5-8.5 (1% aqueous solution) where the number of repeating oxy-1,2-ethanediyl units (n) in BC-10 is 10 and in BC-20 is 20. The pendant double bond is reactive in the latex emulsion preparation if a slightly higher temperature is used, higher amounts of redox catalyst are employed, and a hydrophilic monomer is included in the monomer mix. From 1.0 wt% to 4.0 wt-%, preferably from 2.0 wt% to 3 wt% of the reactive emulsifier based on the total weight of the latex, is used.

While use of a reactive emulsifier can be employed with a variety of latex emulsions for formulating the novel PSA's, a preferred latex emulsion is disclosed in commonly-assigned application serial no. 09/290,159, filed on April 12, 1999. The monomers used to prepare such aqueous lattices include alkyl acrylates, ethylenically unsaturated carboxylic acids and their corresponding anhydrides and styrenic monomers.

Alkyl acrylates are alkyl esters of acrylic or methacrylic acid having at least 4 carbon atoms in the alkyl portion of the molecule. Examples include butyl acrylate, isobutyl acrylate, heptyl acrylate, octyl acrylate, isooctyl acrylate, 2-ethylhexyl acrylate, and isodecyl acrylate. A single alkyl acrylate or mixtures of more than one alkyl acrylate can be used. A preferred alkyl acrylate is 2-ethylhexyl acrylate. The alkyl acrylate monomers are present in the monomer mixture in an amount from 50 wt-% to 90 wt-% and more preferably from 60 wt-% to 65 wt-% based on the total weight of the monomer mixture.

Examples of ethylenically unsaturated carboxylic acids and their corresponding anhydrides used in the present invention include acrylic acid, methacrylic acid, maleic acid, fumaric acid, itaconic acid, beta-carboxyethyl acrylate and maleic anhydride. A single ethylenically unsaturated carboxylic acid or its corresponding anhydride or mixtures thereof can be used. A preferred carboxylic acid is beta-carboxyethyl acrylate. The ethylenically unsaturated carboxylic acids or their corresponding anhydrides are preferably present in the monomer mixture in amounts from 2 wt % to 10 wt%, more preferably from 5 wt-% to 10 wt%, and most preferably from 6 wt% to 8 wt-% based on the total weight of the monomer mixture.

Examples of styrenic monomers used in the present invention include styrene, t-butyl styrene, dimethyl styrene, and vinyl toluene. A preferred monomer is styrene.

The styrenic monomers are present in the monomer mixture in amounts ranging from 15 wt-% to 40 wt-%, and advantageously from 28 wt-% to 34 wt-%, based on the total weight of the monomer mixture.

Optionally, up to 100 % of the styrenic monomer content can be replaced with one or more monomers, selected from the group consisting of methyl methacrylate (MMA), isobornyl acrylate, and vinyl acetate.

Useful crosslinkers include internal crosslinkers. Examples of useful internal crosslinkers include vinyl triethoxysilane, dimethacrylate and N- (iso-butoxymethyl) acrylamide. The crosslinkers are preferably present in amounts up to 1 wt% based on the total weight of the monomer mixture.

Useful chain transfer agents include those known in the art an example of which includes n-dodecyl mercaptan. The chain transfer agent is preferably present in amounts up to 0.5 wt% based on the total weight of the monomer mixture.

When crosslinkers and chain transfer agents are used in combination in the preparation of the latex emulsion, pressure sensitive adhesives prepared using the latex emulsion exhibit enhanced adhesion especially on low energy materials such as high density polyethylene (HDPE) and low density polyethylene (LDPE) while maintaining good cohesive strength and water whitening resistance.

A redox type free radical initiator system is used to promote polymerization of the monomers. The initiator is peroxide or hydroperoxide such as t-butyl hydroperoxide. The reducing agent used in the redox system is zinc formaldehyde sulfoxylate, sodium formaldehyde sulfoxylate, ascorbic acid, isoascorbic acid, sodium metabisulfite and the like. A preferred redox type system consists of t-butyl hydroperoxide and zinc formaldehyde sulfoxylate.

The aqueous latex emulsions, which form the basis of the pressure sensitive adhesives of the present invention, are prepared in a single stage synthesis with or without a seed in the reaction vessel prior to beginning the monomer feed. Reaction temperatures during the monomer feed can range from 50°C to 90°C. In a preferred method of preparing the aqueous latex a pre-emulsion, an aqueous solution of the initiator, and an aqueous solution of a reducing agent are prepared in separate vessels. A reaction vessel is charged with deionized water, an anionic surfactant and a predetermined amount of initiator. The mixture in the reaction vessel is heated with stirring and up to 20 wt % of the pre-emulsion, more preferably up to 8 wt-% and most preferably 4 wt-% is added to the reaction vessel along with a predetermined amount of the reducing agent to form the seed. In small batches such as laboratory size synthesis the predetermined amount of reducing agent, the"initial Zn hit", can be added before the initial pre-emulsion charge. In larger scale synthesis it is preferred that the predetermined amount of reducing agent is added after the initial pre-emulsion charge is added to the reaction vessel. After forming the seed, the contents of the reaction vessel are heated to a desired temperature and the pre-emulsion, initiator and the reducing agent are simultaneously metered into the reaction vessel with stirring. It has been found to be advantageous to mix the pre-emulsion and initiator. This can be accomplished by merging the pre-emulsion and initiator feed streams and passing the merged stream through a static mixer or by simply allowing the two feed streams to converge in a common feed line. On completion of the pre-emulsion feed, the contents of the reaction vessel are cooled and alternating predetermined amounts of the initiator and reducing agent are added to the reaction vessel with stirring. This alternating initiator/reducing agent addition is preferably performed at least once. Once the reaction is complete the pH may be adjusted. The pH of the aqueous latex emulsion is preferably adjusted to a pH of about 6 to about 9 and more preferably about 6 to about 7.5. For efficiency and economy an aqueous solution of ammonium hydroxide can be used to adjust the pH. Other bases that may be used include amines, imines, alkali metal and alkaline metal hydroxides, carbonates, etc.

In addition to the aqueous latex emulsion, the pressure sensitive adhesive composition advantageously contains biocides, wetting agents, defoamers, tackifiers and the like. Examples of suitable biocides include Kathon LX, commercially available as a 1.5% solution from Rohm & Haas and Metatin 910, commercially available from ACIMA. An example of a suitable wetting agent is Surfynol SE commercially available from Air Products, PLURONIC^{®} type polyols commercially available from BASF Corp, and the like. Examples of defoamers include Drewplus T-1201 and Drewplus 1-191 commercially available from Ashland Specialty Chemical Company, and Rhodoline 6681, commercially available from Rhodia. Examples of tackifiers include those tackifiers known in the art for use in pressure sensitive adhesive formulations such as, rosin esters, terpene phenolic esters, rosin ester/terpene phenolic hybrids and the like. A preferred tackifier is a rosin ester an example of which is Aquatac 6085 available commercially from Arizona Chemica. Other tackifiers such as terpene phenolic resins an example of which is Dermulsene TR501 and hybrids such as Dermulsene RE 222 available commercially from N&D Dispersions LLC. improve adhesion but cause the loss of some blush resistance

The pressure sensitive adhesives described above can be used to prepare articles such as tapes, labels, signs, marking films, and the like. In a typical construction the pressure sensitive adhesive is coated or otherwise applied to a release liner such as a siliconized paper, dried, and laminated to a facestock. Alternatively, the pressure sensitive adhesive is coated directly on a facestock. Examples of facestocks include cellulosics, metal foils, polycarbonates, polyethylene (both HDPE and LDPE), polypropylene, polyethylene terephthalate, and vinyl films.

The pressure sensitive adhesives typically have a viscosity after adjusting the pH to between about 6 and about 8 of from about 1,000 to about 20,000 centipoises at 25°C. The pressure sensitive adhesives exhibit a shear-thinning rheology such that it allows coating even on difficult to coat films. Conventional coating techniques can be used to apply the pressure sensitive adhesives. Such techniques include dipping, slot die, air knife, brush curtain, extrusion blade, reverse roll, squeeze roll coating, In this application all units are in the metric system and all amounts and percentages are by weight, unless otherwise expressly indicated.

### IN THE EXAMPLES

The following test procedures were used in the examples:
1. 180° Peel Test: PSTC-1 (November 1975), Pressure Sensitive Tape Council, Glenview, III. Results of this test are reported in pounds/inch for a 1 in strip.
2. 178° Shear Test: Modified PSTC-7 using 1 x 1 x 4 Ibs (November 1975).
   Pressure Sensitive Tape Council. Results of this test are reported in hours/500 gm/0.25 in² at 22°C.
3. Polyken Tack Test: This test is conducted on a Polyken, Jr. Probe Tack Tester (Polyken is a trademark of the Kendall Company) supplied by Testing Machines, Inc. (Amityville, N.Y.) under the following conditions:
   - Probe:: 304 SS. 0.5 cm. diameter probe with a 280 grit abrasive finish.
   - Dwell Time:: 1 second
   - Probe Contact Pressure:: 100 gm/cm²
   - Probe Retraction Rate:: 1 cm/sec.
   - Annular Weight:: 20 gm. - 100 gm/cm² pressure of a 0.5 cm. diameter probe
   - Procedure:: A one-inch square of MYLAR polyester film coated with the adhesive is placed on top of the annular weight so that the hole is completely covered by the adhesive area and this assembly placed in the weight carrier well. The machine is activated and the sequence of probe pressure and probe retraction automatically accomplished. The force required to free the probe from adhesive coated film, measured in grams/cm² is read from the indicator dial on the machine.
4. Tap Water Immersion and Blush Test.
   An adhesive is coated to 2 mil MYLAR polyester film, dried at 90° C for 5 minutes. The adhesive coated polyester facestock is immersed in a jar of tap water. The film is observed for development of haze or discoloration over a period of time.

### Reference EXAMPLE 1

**TABLE 1**

| Composition of 6448-79 Latex | |
|---|---|
| Component | Wt-% Based on Latex |
| Water | 51.80 |
| Sodium bicarbonate | 0.10 |
| Hitenol BC-10* | 1.12 |
| 70% *t*-Butyl hydroperoxide | 0.19 |
| 2-Ethyl hexylacrlate | 32.27 |
| Styrene | 7.61 |
| Methyl methacrylate | 3.81 |
| β -carboxyethyl acrylate | 2.48 |
| Methacrylic acid | 1.50 |
| Zinc formaldehyde sulfoxylate | 0.12 |

| | |
|---|---|
| *Hitenol BC-10 is poly(oxy-1,2-ethanediyl),α-sulfo-ω-[4-nonyl-2-(1-propenyl)phenyoxy]-branched ammonium salts; yellowish brownish viscous liquid, 97.0 % actives, combined sulfuric acid content of 8.70-9.70%, actives, combined sulfuric acid content of 8.70-9.70%, pH of 6.5-8.5 (1% aqueous solution), supplied by Montello, Tulsa, OK. | |

A typical synthesis is set forth below.

### Preparation of the Pre-Emulsion

To a 500 ml. pre-emulsion vessel equipped with a turbine agitator was charged de-ionized water (64.8 g.), NaHCO₃ (0.4 g.), 70% t-butyl hydroperoxide initiator (t-BHP, 0.60 g.), and Hitenol BC-10 polymerizable anionic surfactant (3.6 g.). The agitation was adjusted to 400 rpm. A monomer solution consisting of beta-carboxyethyl acrylate (β-CEA, 10.0 g.), methacrylic acid (MAA, 2.0 g.), methyl methacrylate (MMA, 15.33 g.), 2-ethylhexyl acrylate (2-EHA, 129.9 g), and styrene (30.65 g.) then was slowly added to the vessel. Agitation of the emulsion was continued for 35 minutes after which the pre-emulsion was transferred to the reservoir of a metering pump system for eventual delivery to the polymerization reaction vessel.

### Preparation of The Reducing Agent Feed Solution

A solution of zinc formaldehyde sulfoxylate (ZFS, 0.35 g) in de-ionized water (12.0 g) was prepared and added to the reservoir of a peristaltic pump for eventual deliver to the polymerization reaction vessel.

### Reactor charge and polymerization

To a 500 ml. reaction vessel equipped with a turbine agitator, thermocouple, heating mantle, temperature regulating device, N₂ sparge, and delivery lines for the pre-emulsion and reducing agent, was added de-ionized water (118.1 g.) and Hitenol BC-10 polymerizable surfactant (0.90 g). A N₂ sparge was started, the agitation set at 200 rpm, and the heating mantle was turned on. When the temperature reached 60° C, the N₂ sparge was turned off and 4% (~12 ml.) of the pre-emulsion was pumped into the reaction vessel. When the temperature reached 70° C, a single addition of ZFS reducing agent (0.07 g.) solution in de-ionized water (5.0 g.) was added. Formation of a translucent blue dispersion within a few minutes indicated that the polymerization had initiated. Heating was continued to the controlled polymerization temperature of 80° C, whereupon the pre-emulsion and ZFS reducing agent feeds were started. The addition rates were adjusted to complete the deliveries over a three-hour time period at a reaction temperature of 80° C. Ten minutes after completion of the feeds, additional initiator (70% t-BHP, 0.075 g.) in de-ionized water (1.25 g.) was added, followed after another 10 minutes reaction time by additional ZFS reducing agent (0.03 g.) in de-ionized water (1.25 g.). The reaction was held at 80° C for one additional hour after which cooling was started. When the temperature reached 50° C additional initiator (70% t-BHP, 0.075 g.) in de-ionized water (1.25 g.) was added, followed after another 10 minutes by additional ZFS reducing agent (0.03 g.) in de-ionized water (1.25 g.). Cooling was continued to a temperature < 30° C at which point the latex was removed.

Additional formulations were compounded as above and evaluated for their properties. The formulations evaluated and results recorded are set forth in Table 2:

**TABLE 2 (Reference Examples 2 to 11)**

| % BOM | 2 | 3 | 4 | 5 | 6 | 7 | 8 | 9 | 10 | 11 |
|---|---|---|---|---|---|---|---|---|---|---|
| 2-Ethyl hexylacrylate | 58.6 | 58.6 | 69.15 | 69.15 | 65.55 | 68.36 | 73.71 | 72.51 | 72.51 | 60.37 |
| Styrene | 0 | 16.31 | 16.31 | 8.16 | 16.31 | 8.16 | 0 | 0 | 0 | 30.72 |
| Methyl methacrylate | 32.62 | 16.31 | 8.16 | 16.31 | 8.16 | 16.31 | 16.31 | 16.31 | 16.31 | - |
| β-carboxyethyl acryate | 5.32 | 5.32 | 5.32 | 5.32 | 5.32 | 3.57 | 5.32 | 5.32 | 5.32 | 5.12 |
| Methacrylic acid | 1.06 | 1.06 | 1.06 | 1.06 | 1.06 | 0 | 1.06 | 1.06 | 1.06 | 1.02 |
| Hitenol BC-10 | 2.4 | 2.4 | 2.4 | 2.4 | 3.6 | 3.6 | 3.6 | 4.8 | 4.8 | 2.77 |

| TEST RESULTS | | | | | | | | | | |
|---|---|---|---|---|---|---|---|---|---|---|
| Shear (1 x 1 x 4 Ib) | 144+ | 144+ | 102.6 cf | 104 cf | 87+ | 15.9 cf | 11.5 cf | 12.4 cf | 35.7 cf | 17.86 |
| 15 min. peel | 2.3 cl | 2.4 cl | 2.2 cl | 2.2 cl | 2.3 cl | 2.32 cl | 1.9 cl | 1.5 cl | 1.5cl | 2.6 cl |
| 24 hr peel | 3.0 cl | 3.5 cl | 3.2 cl | 3.1 cl | 3.0 cl | 2.9 cl | 2.8 cl | 2.4 cl | 2.3 cl | 3.9 cl |
| Polyken tack test | 40 | 67 | 183 | 107 | 151 | 197 | 203 | 242 | 218 | 470 |
| Particle Size (nm) | 100 | 86.1 | 86 | 88 | 81.8 | 81.5 | 92 | 86.4 | 97.6 | 82.1 |
| Blush (days) (tap water immersion) | 19+ | 16+ | 2 | 14+ | 10+ | 6 | 7+ | 4+ | 3+ | 3+ |

### Adhesive Failure Code:

cl = clean, adhesive failure

cf = cohesive failure

+ = greater than

The above-tabulated results demonstrate the remarkable properties exhibited by the PSA's that utilize an aqueous latex emulsion PSA that employs a reactive emulsifier as the only emulsifier used to make the latex emulsion. Addition of nonreactive emulsifiers, while a small amount is tolerable, will degrade the otherwise excellent performance exhibited by the inventive PSA's. Note also that in example 11 no hard monomer (MMA) was used and the remarkable properties still were exhibited.

The latex formulation in Table 3 contains an internal crosslinker and a chain transfer agent as well as a mixture of two polymerizable anionic surfactants.

**Table 3**

| Component | Wt-% Based on Latex |
|---|---|
| Water | 55.5 |
| Sodium bicarbonate | 0.09 |
| Hitenol BC-10* | 0.834 |
| Hitenol BC-20* | 0.379 |
| 70% t-Butyl hydroperoxide | 0.202 |
| 2-Ethyl hexylacrylate | 30.82 |
| Styrene | 0.87 |
| Methyl methacrylate | 7.91 |
| β-carboxyethyl acrylate | 2.95 |
| Methacrylic acid | 0.01 |
| Zinc formaldehyde sulfoxylate | 0.12 |
| Vinyl Triethoxysilane A-151 | 0.04 |
| n-dodecyl mercaptan | 0.06 |

| | |
|---|---|
| *: Hitenol BC-10 and Hitenol BC-20 are poly(oxy-1,2-ethanediyl), α-sulfo-ω-[4-nonyl-2-(1-propenyl)phenyoxy]-branched ammonium salts; yellowish brownish viscous liquid, 97% actives, combined sulfuric acid content of 8.70-9.70%, pH of 6.5-8.5 (1% aqueous solution), supplied by Montello, Tulsa, OK. | |

A typical synthesis is set forth below:
Preparation of the Pre-Emulsion:
   To a 2000 ml. Pre-emulsion vessel equipped with a turbine agitator was charged de-ionized water (218.0 g.), NaHCO. Sub.3 (1.4 g.), 70% t-butyl hydroperoxide initiator (t-BHP, 1.9 g.), and Hitenol BC-10 and Hitenol BC-20 polymerizable anionic surfactants (14.6 g.). The agitation was adjusted to 400 rpm. A monomer solution consisting of beta-carboxyethyl acrylate (.beta.CEA, 44.3 g.) methacrylic acid (MAA, 0.2 g.), methyl methacrylate (MMA, 118.6g.), 2-ethyl acrylate (2-EHA, 462.1 g), styrene (13.0 g.), Silquest A-151 (0.8 g.), and n-dodecyl Mercaptan (n-DDM, 0.9 g,) then was slowly added to the vessel. Agitation of the emulsion was continued for 30 minutes after which the pre-emulsion was transferred to the reservoir of a metering pump system for eventual delivery to the polymerization reaction vessel.
Preparation of the Reducing Agent Feed Solution:
   A solution of zinc formaldehyde solfoxylate (ZFS, 1.15 g.) in de-ionized water (42.0 g.) was prepared and added to the reservoir of a peristaltic pump for eventual deliver to the polymerization reaction vessel.

### Reactor Charge and Polymerization

To a 2000 ml. reaction vessel equipped with a turbine agitator, thermocouple, circulated water bath, temperature regulating device, N.sub.2 sparge, and delivery lines for the pre-emulsion and reducing agent, was added de-ionized water (462.0 g.) and Hitenol BC-10 polymerizable surfactant (3.6 g.). A N.sub.2 sparge was started, the agitation set at 200 rpm, and circulated water bath was turned on. When the temperature reached 70.degree.C., pre-emulsion (35.0 g.) was charged in the vessel and a single addition of ZFS reducing agent (0.2 g.) solution in de-ionized water (20.0 g.) was added. Formation of a translucent blue dispersion within a few minutes indicated that polymerization had initiated. Heating was continued to the controlled polymerization temperature of 80.degree. C., whereupon the pre-emulsion and ZFS reducing agent feeds were started. The addition rates were adjusted to complete the deliveries over a three-hour time period at a reaction temperature of 80.degree. C. Ten minutes after completion of the feeds, additional initiator (70% t-BHP, 0.51 g.) in deionized water (2.0 g.) was added, followed after another ten minutes reaction time by additional ZFS reducing agent (0.2 g.) in de-ionized water (2.0 g.). The reaction was held at 80.degree. C. for one additional hour after which cooling was started. When the temperature reached 50.degree. C., additional initiator (70% t-BHP), 0.51 g.) in de-ionized water (2.0 g.) was added, following after another 10 minutes by additional ZFS reducing agent (0.2 g.) in de-ionized water (2.0 g.). Cooling was continued to a temperature < 30. degree. C. at which point the latex was neutralized with ammonia then filtered through a 300 cotton cheese cloth.

### Reference Example 12

To a 2000 mL., four necked jacketed glass reactor equipped a turbine agitator, thermocouple, circulated water bath, N.sub.2 sparge, and delivery lines for the pre-emulslon and reducing agent, was added de-ionized water (462.0 g.) and Hitenol BC-10 polymerizable surfactant (3.6 g.). A N.sub.2 sparge was started, the agitation set at 200 rpm, and circulated water bath was turned on. A monomer mix consisting of 33.7 g of carboxyethyl acrylate, 0.2 g of methacrylic acid, 475.0 g of 2-ethylhexyl acrylate, 132.0g of styrene was added to 217.1g of water containing 1.3g of sodium bicarbonate, 1.9g of 70% t-butyl hydroperoxide initiator, and 14.6g of Hitenol BC-10 polymerizable anionic surfactant and was agitated for sufficient time until the formation of a stable pre-emulsion feed. Separately, A reductant feed containing 1.2 g zinc formaldehyde solfoxylate in 42g of water was prepared and added to the reservoir of a peristaltic pump for eventual deliver to the polymerization reaction vessel. When the temperature reached 70.degree.C., 35.0g of pre-emulsion was charged in the vessel and a single addition of 0.2g of ZFS reducing agent in 20.0g of water was added. Formation of a translucent blue dispersion within a few minutes indicated that polymerization had initiated. Heating was continued to the controlled polymerization temperature of 80.degree. C., whereupon the pre-emulsion and ZFS reducing agent feeds were started. The addition rates were adjusted to complete the deliveries over a three-hour time period at a reaction temperature of 80.degree. C. Ten minutes after completion of the feeds, additional 0.51g of initiator 70% t-BHP in 2.0g of water was added, followed after another ten minutes reaction time by additional 0.2g of ZFS reducing agent in 2.0g of water (2.0 g.). The reaction was held at 80.degree. C. for one additional hour after which cooling was started. When the temperature reached 50.degree. C., additional 0.51g of initiator 70% t-BHP in 2.0g of water was added, following after another 10 minutes by additional 0.2g of ZFS reducing agent in 2.0g of water. Cooling was continued to a temperature < 30. degree. C. at which point the latex was neutralized with ammonia then filtered through a 300 cotton cheese cloth. The resulting composition had solids content of 44%, a percent coagulum of less than 0.01% and a viscosity of about 500 centipoise as measured by Brook-field viscometer, and a pH of 6.8.

### Reference Example 13

Example No. 12 was repeated with the exception that pre-emulsion mix contained 0.2g n-dodecyl mercaptan.

### Example 14

Example No. 12 was repeated with the exception that pre-emulsion mix contained 44.3 g of carboxyethyl acrylate, 0.3g of methacrylic acid, 462.7 g of 2-ethylhexyl acrylate, 0.63g of Silane A151 and 0.6g n-dodecyl mercaptan.

### Example 15

Example No.14 was repeated with the exception that pre-emulsion mix contained 0.40g of Silane A151 and 0.73g n-dodecyl mercaptan.

### Reference Example 16

Example No.12 was repeated with the exception that pre-emulsion mix contained 44.3g of carboxyethyl acrylate, 0.2 g of Methacrylic acid, 462.1 g of 2-ethylhexyl acrylate, 13.1g of styrene, 118.6g of methyl methacrylate, 8.9g Hitenol BC-10, 5.7g Hitenol BC-20, 0.84g of Silane A151, and 219.0g of water.

### Example 17

Example No.16 was repeated with the exception that pre-emulsion mix contained 0.2g of n-dodecyl mercaptan.

### Example 18

Example No.16 was repeated with the exception that pre-emulsion mix contained 0.9 g of n-dodecyl mercaptan.

### Example 19

Example No.14 was repeated with addition of 20% Rosin Ester tackifier in PSA formulation.

### Example 20

Example No.15 was repeated with addition of 20% Rosin Ester tackifier in PSA formulation.

### Example 21

Example No.18 was repeated with addition of 20% Rosin Ester tackifier in PSA formulation.

### Example 22

Example No.18 was repeated with the exception that pre-emulsion mix contained 35.3g of carboxyethyl acrylate, 457.6 g of 2-ethylhexyl acrylate, 23.5 g of styrene, 109.6 g of methyl methacrylate, 12.9 g of N-(iso-Butoxymethyl) acrylamide.

### Example 23

Example No.12 was repeated with the exception that pre-emulsion mix contained 0.4 g of 1,3-Butanediol dimethacrylate and 0.73 g of n-dodecyl mercaptan.

### Example 24

Example No.22 was repeated with addition of 20% Rosin Ester tackifier in PSA formulation.

The pressure sensitive adhesives of Examples 12-24above were coated onto a 2 mil Mylar film. The film was heat dried at 90°C oven for 5 minutes. The coated Mylar was laminated with release liner for further testing.

**Table 4**

| | Reference Ex 12 | Reference Ex 13 | Ex 14 | Ex 15 | Reference Ex 16 | Ex 17 | Ex 18 | Ex 22 | Ex 23 |
|---|---|---|---|---|---|---|---|---|---|
| %BOM | | | | | | | | | |
| 2-Ethyl hexylacrylate | 72.1 | 72.1 | 70.3 | 70.3 | 70.3 | 70.3 | 70.3 | 69.5 | 72.1 |
| Styrene | 20 | 20 | 20 | 20 | 1.9 | 1.9 | 1.9 | 3.6 | 20 |
| Methyl methacrylate | - | - | - | - | 18 | 18 | 18 | 16.7 | - |
| β-carboxyethyl acrylate | 5.1 | 5.1 | 6.7 | 6.7 | 6.7 | 6.7 | 6.7 | 5.4 | 5.1 |
| Methacrylic acid | 0.02 | 0.02 | 0.02 | 0.02 | 0.02 | 0.02 | 0.02 | 0.02 | 0.02 |
| Vinyl Triethoxysilane A-151 | - | - | 0.1 | 0.1 | 0.1 | 0.1 | 0.1 | - | - |
| N (iso-Butoxymethyl) acrylamide | - | - | - | - | - | - | - | 1.96 | - |
| 1,3-Butanediol dimethacryalte | - | - | - | - | - | . | - | - | 0.03 |
| n-dodecyl mercaptan | - | 0.03 | 0.09 | 0.11 | - | 0.02 | 0.13 | 0.13 | 0.11 |
| Hitenol BC-10 | 2.8 | 2.8 | 2.8 | 2.8 | 2.0 | 2.0 | 2.0 | 2.0 | 2.8 |
| Hitenol BC-20 | - | - | - | - | 0.87 | 0.87 | 0.87 | 0.87 | - |
| Test Results | | | | | | | | | |
| Shear (1x1x4 lb) | 5 cf | 5 cf | 8.9 cf | 16 cf | 24+ | 24+ | 24+ | 4c | 4c |
| 30 min. peel on stainless steel | 2.6 cl | 3.2 cl | 3.9 cl | 4.1 cl | 1.9 cl | 2.3 cl | 2.8 cl | 3.0 cl | 3.9 cl |
| 24 hours peel on stainless steel | 4.1 cl | 5.5 cl | 6.2 cf | 6.3 cf | 3.3 cl | 3.8 cl | 4.5 cf | 4.5 cf | 6.9 cf |
| 30 min. peel on HYPE | 0.3 cl | 0.2 cl | 1.0 cl | 0.9 cl | 0.2 cl | 0.3 cl | 0.4 cl | 0.4 cl | 0.8 cl |
| 24 hours peel on HDPE | 0.3 cl | 0.4 cl | 0.8 cl | 1.4 cl | 0.3 cl | 0.4 cl | 0.5 cl | 0.5 cl | 1.3 cl |
| Polyken tack test (grams) | 318 | 281 | 389 | 393 | 234 | 262 | 394 | 493 | |
| Blush (days) (tap water immersion) | 3+ | 3+ | 3+ | 3+ | 3+ | 3+ | 3+ | 3+ | 3+ |

By combination of chain transfer agent n-dodecyl mercaptan and crosslinkers (silane, N-(iso-Butoxymethyl) acrylate, and 1,3-butanediol dimethacrylate, etc), the adhesion to polyolefin surface such as HDPE is greatly improved while the adhesive still has excellent blush resistant.

The adhesion to low energy surface can be further improved when the above adhesives were formulated with Rosin Ester tackifiers such as Aquatac 6085.

**Table 5**

| | Ex 19 | Ex 20 | Ex 21 | Ex 22 |
|---|---|---|---|---|
| | | | | |
| Test Results | | | | |
| Shear (1x1x4 lb) | 6 cf | 10 cf | 8.9 cf | 8.9 cf |
| 30 min. peel on stainless steel | 4.4 cl | 4.4 cl | 4.2 cl | 3.3 cl |
| 24 hours peel on stainless steel | 5.9 cf | 5.8 cf | 4.9 cf | 4.0 cl |
| 30 min. peel on HDPE | 2.2 cl | 1.4 cl | 1.5 cl | 0.9 cl |
| 24 hours peel on HDPE | 2.0 cl | 1.7 cl | 1.3 cl | 1.5 cl |
| Polyken tack test (grams) | 255 | 506 | 465 | 493 |
| Blush (days) (tap water immersion) | 1+ | 1+ | 1+ | 1+ |

| | | | | |
|---|---|---|---|---|
| Example 19 was tackified example 14 (20 wt-%) Example 20 was tackified example 15 (20 wt-%) Example 21 was tackified example 18 (20 wt-%) Example 24 was tackified example 22 (20wt-%) Tackifier was added to the formulation after polymerization step. | | | | |

## Claims

1. An aqueous, blush-retardant pressure sensitive adhesive, which comprises an aqueous latex emulsion having an average particle size diameter of less than or equal to 100 nm consisting essentially of:
a) at least one alkyl acrylate having at least 4 carbon atoms in the alkyl group;
b) at least one ethylenically unsaturated carboxylic acid or its corresponding anhydride;
c) at least one styrenic monomer, wherein optionally, up to 100% of the styrenic monomer is replaced with one or more monomers selected from the group consisting of methyl methacrylate, isobornyl acrylate, and vinyl acetate;
d) a crosslinker;
e) a chain transfer agent;
f) a monomer mixture comprising beta-carboxyethyl acrylate;
g) a redox type free radical initiator system; and
h) an emulsifier of the formula 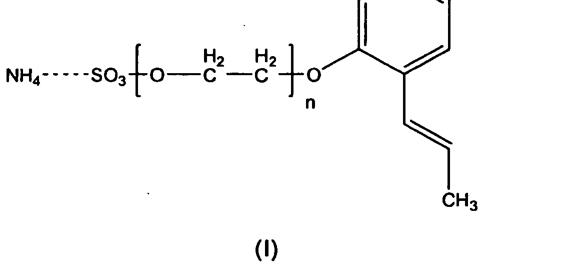 wherein n is an integer from 1-200.

2. The pressure sensitive adhesive of claim 1, wherein the alkyl group of said alkyl acrylate having at least 4 carbon atoms in the alkyl group is one or more of butyl acrylate, 2-ethylhexyl acrylate, heptyl acrylate, octyl acrylate, isooctyl acrylate, isobutyl acrylate, or isodecyl acrylate.

3. The pressure sensitive adhesive of claim 1, where the ethylenically unsaturated carboxylic acid or its corresponding anhydride is one or more of acrylic acid, methacrylic acid, beta-carboxyethyl acrylate, maleic acid, fumaric acid, itaconic acid, or maleic anhydride.

4. The pressure sensitive adhesive of claim 1, wherein the styrenic monomer is one or more of styrene, tert-butyl styrene, dimethyl styrene, or vinyl toluene.

5. The pressure sensitive adhesive of claim 1, which further comprises a wetting agent.

6. The pressure sensitive adhesive of claim 1, which further comprises a tackifier.

7. The pressure sensitive adhesive of claim 6, wherein the tackifier comprises a rosin ester.

8. The pressure sensitive adhesive of claim 1, wherein the crosslinker is present in the aqueous latex in an amount of up to 1 wt.%, based on the total weight of the monomer mixture.

9. The pressure sensitive adhesive of claim 1, wherein the chain transfer agent is present in an amount of up to 0.5 wt.-%, based on the total weight of the monomer mixture. _. -

10. The pressure sensitive adhesive of claim 1, wherein the at least one alkyl acrylate having at least 4 carbon atoms in the alkyl group is present in the monomer mixture in an amount from 50 wt.% to 90 wt.-%, based on the total weight of the monomer mixture.

11. The pressure sensitive adhesive of claim 1, wherein the at least one ethylenically unsaturated carboxylic acid or its corresponding anhydride is present in the monomer mixture in amounts from 2 wt.-% to 10 wt.-%, based on the total weight of the monomer mixture.

12. The pressure sensitive adhesive of claim 1, wherein the at least one styrenic monomer is present in the monomer mixture in amounts ranging from 15 wt.% to 40 wt.%, based on the total weight of the monomer mixture.

13. The pressure sensitive adhesive of claim 1, wherein the emulsifier of the formula (I) is present in the monomer mixture in amounts from 1.0 wt.% to 4.0 wt.%, based on the total weight of the monomer mixture.

14. A laminate comprising (a) a release liner, (b) a facestock, and (c) the pressure sensitive adhesive according to any claims 1 to 13 between and adhering the release liner and facestock.

15. A tape comprising a wound roll of facestock having an exterior side and an interior side, the interior side coated with the pressure sensitive adhesive of any of claims 1 to 13.

## Patentansprüche

1. Wässriger, weißanlaufbeständiger Haftklebstoff, der eine wässrige Latexemulsion mit einem mittleren Teilchengrößendurchmesser kleiner gleich 100 nm umfasst, die im Wesentlichen aus:
a) mindestens einem Alkylacrylat mit mindestens 4 Kohlenstoffatomen in der Alkylgruppe,
b) mindestens einer ethylenisch ungesättigten Carbonsäure oder ihrem korrespondierenden Anhydrid und
c) mindestens einem Styrolmonomer, wobei gegebenenfalls bis zu 100% des Styrolmonomers durch ein oder mehrere Monomere aus der Gruppe bestehend aus Methylmethacrylat, Isobornylacrylat und Vinylacetat ersetzt sind;
d) einem Vernetzer;
e) einem Kettenübertragungsmittel;
f) einer Monomerenmischung, die beta-Carboxyethylacrylat umfasst;
g) einem radikalischen Initiatorsystem vom Redoxtyp und
h) einem Emulgator der Formel 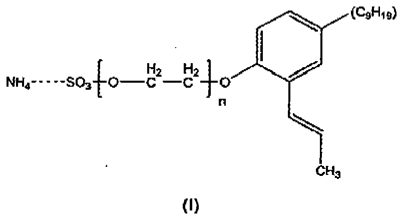 worin n für eine ganze Zahl von 1-200 steht; besteht.

2. Haftklebstoff nach Anspruch 1, wobei es sich bei der Alkylgruppe des Alkylacrylats mit mindestens 4 Kohlenstoffatomen in der Alkylgruppe um Butylacrylat, 2-Ethylhexylacrylat, Heptylacrylat, Octylacrylat, Isooctylacrylat, Isobutylacrylat und/oder Isodecylacrylat handelt.

3. Haftklebstoff nach Anspruch 1, wobei es sich bei der ethylenisch ungesättigten Carbonsäure oder ihrem korrespondierenden Anhydrid um Acrylsäure, Methacrylsäure, beta-Carboxyethylacrylat, Maleinsäure, Fumarsäure, Itaconsäure und/oder Maleinsäureanhyrid handelt.

4. Haftklebstoff nach Anspruch 1, wobei es sich bei dem Styrolmonomer um Styrol, tert.-Butylstyrol, Dimethylstyrol und/oder Vinyltoluol handelt.

5. Haftklebstoff nach Anspruch 1, der ferner ein Netzmittel umfasst.

6. Haftklebstoff nach Anspruch 1, der ferner einen Klebrigmacher umfasst.

7. Haftklebstoff nach Anspruch 6, wobei der Klebrigmacher einen Kolophoniumester umfasst.

8. Haftklebstoff nach Anspruch 1, wobei der Vernetzer in dem wässrigen Latex in einer Menge von bis zu 1 Ges.-%, bezogen auf das Gesamtgewicht der Monomerenmischung, vorliegt.

9. Haftklebstoff nach Anspruch 1, wobei das Kettenübertragungsmittel in einer Menge von bis zu 0,5 Gew.-%, bezogen auf das Gesamtgewicht der Monomerenmischung, vorliegt.

10. Haftklebstoff nach Anspruch 1, wobei das mindestens eine Alkylacrylat mit mindestens 4 Kohlenstoffatomen in der Alkylgruppe in der Monomerenmischung in einer Menge von 50 Gew.-% bis 90 Gew.-%, bezogen auf das Gesamtgewicht der Monomerenmischung, vorliegt.

11. Haftklebstoff nach Anspruch 1, wobei die mindestens eine ethylenisch ungesättigte Carbonsäure oder ihr korrespondierendes Anhydrid in der Monomerenmischung in Mengen von 2 Ges.-% bis 10 Gew.-%, bezogen auf das Gesamtgewicht der Monomerenmischung, vorliegt.

12. Haftklebstoff nach Anspruch 1, wobei das mindestens eine Styrolmonomer in der Monomerenmischung in Mengen von 15 Gew.-% bis 40 Gew.-%, bezogen auf das Gesamtgewicht der Monomerenmischung, vorliegt.

13. Haftklebstoff nach Anspruch 1, wobei der Emulgator der Formel (I) in der Monomerenmischung in Mengen von 1,0 Ges.-% bis 4,0 Ges.-%, bezogen auf das Gesamtgewicht der Monomerenmischung, vorliegt.

14. Laminat, umfassend (a) einen Releaseliner, (b) ein Trägermaterial und (c) den Haftklebstoff nach einem der Ansprüche 1 bis 13, der zwischen dem Releäseliner und dem Trägermaterial angeordnet ist und den Releaseliner und das Trägermaterial verklebt.

15. Band, umfassend eine aufgewickelte Rolle von Trägermaterial mit einer Außenseite und einer Innenseite, wobei die Innenseite mit dem Haftklebstoff nach einem der Ansprüche 1 bis 13 beschichtet ist.

## Revendications

1. Adhésif autocollant aqueux retardant l'opalescence, qui comprend une émulsion aqueuse de latex ayant un diamètre moyen de particules inférieur ou égal à 100 nm, essentiellement composé de :
a) au moins un acrylate d'alkyle portant au moins 4 atomes de carbone dans le groupe alkyle ;
b) au moins un acide carboxylique éthyléniquement insaturé ou son anhydride correspondant ;
c) au moins un monomère styrénique, jusqu'à 100 % du monomère styrénique étant éventuellement remplacés par un ou plusieurs monomères choisis dans le groupe constitué par le méthacrylate de méthyle, l'acrylate d'isobornyle et l'acétate de vinyle ;
d) un agent de réticulation ;
e) un agent de transfert de chaîné
f) un mélange de monomères comprenant de l'acrylate de bêta-carboxyéthyle ;
g) un système initiateur de radicaux libres de type redox ; et
h) un émulsifiant de formule 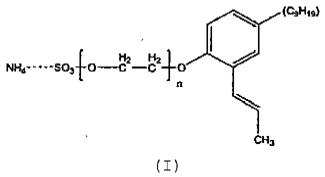 dans laquelle n est un entier valant 1-200.

2. Adhésif autocollant selon la revendication 1, dans lequel le groupe alkyle dudit acrylate d'alkyle portant au moins 4 atomes de carbone dans le groupe alkyle est l'acrylate de butyle, l'acrylate de 2-éthylhexyle, l'acrylate d'heptyle, l'acrylate d'octyle, l'acrylate d'isooctyle, l'acrylate d'isobutyle ou l'acrylate d'isodécyle, ou plusieurs d'entre eux.

3. Adhésif autocollant selon la revendication 1, dans lequel l'acide carboxylique éthyléniquement insaturé ou son anhydride correspondant est l'acide acrylique, l'acide méthacrylique, l'acrylate de bêta-carboxyéthyle, l'acide maléique, l'acide fumarique, l'acide itaconique ou l'anhydride maléique, ou plusieurs d'entre eux.

4. Adhésif autocollant selon la revendication 1, dans lequel le monomère styrénique est le styrène, le tert-butylstyrène, le diméthylstyxène ou le vinyltoluène, ou plusieurs d'entre eux.

5. Adhésif autocollant selon la revendication 1, comprenant en outre un agent mouillait.

6. Adhésif autocollant selon la revendication 1, comprenant en outre un agent poisseux.

7. Adhésif autocollant selon la revendication 6, dans lequel l'agent poisseux comprend un ester de colophane.

8. Adhésif autocollant selon la revendication 1, dans lequel l'agent de réticulation est présent dans le latex aqueux dans une quantité allant jusqu'à 1% en poids, rapporté au poids total du mélange de monomères.

9. Adhésif autocollant selon la revendication 1, dans lequel l'agent de transfert de chaîne est présent dans une quantité allant jusqu'à 0,5 % en poids, rapporté au poids total du mélange de monomères.

10. Adhésif autocollant selon la revendication 1, dans lequel l'au moins un acrylate d'alkyle portant au moins 4 atomes de carbone dans le groupe alkyle est présent dans le mélange de monomères dans une quantité de 50 % en poids à 90 % en poids, rapporté au poids total du mélange de monomères.

11. Adhésif autocollant selon la revendication 1, dans lequel l'au moins un acide carboxylique éthyléniquement insaturé ou son anhydride correspondant est présent dans le mélange de monomères dans des quantités de 2 % en poids à 10 % en poids, rapporté au poids total du mélange de monomères.

12. Adhésif autocollant selon la revendication 1, dans lequel l'au moins un monomère styrénique est présent dans le mélange de monomères dans des quantités de 15 % en poids à 40 % en poids, rapporté au poids total du mélange de monomères.

13. Adhésif autocollant selon la revendication 1, dans lequel l'émulsifiant de formule (I) est présent dans le mélange de monomères dans des quantités de 1,0 % en poids à 4,0 % en poids, rapporté au poids total du mélange de monomères.

14. Stratifié comprenant (a) un dorsal, (b) un frontal, et (c) l'adhésif autocollant selon l'une quelconque des revendications 1 à 13 entre et collant le dorsal et le frontal.

15. Ruban comprenant un rouleau de frontal ayant un côté extérieur et un côté intérieur, le côté intérieur étant recouvert par l'adhésif autocollant de l'une quelconque des revendications 1 à 13.
